# EUROPÄISCHE PATENTSCHRIFT

(11) **EP 0 971 574 B1**
(45) Veröffentlichungstag und Bekanntmachung des Hinweises auf die Patenterteilung: **26.03.2003**
(21) Anmeldenummer: 99112560.0
(22) Anmeldetag: 01.07.1999
(51) Int. Cl.: H05K 7/20

(54) **Einrichtung zur selbsttätigen Beheizung eines Luftansauggitters für elektrische Geräte**
Automatic air-intake grid heating device for electrical apparatuses
Dispositif de chauffage automatique d'une grille d'admission d'air dans des appareils électriques

(30) Priorität: 07.07.1998 DE 19830340
(43) Veröffentlichungstag der Anmeldung: 12.01.2000
(73) Patentinhaber: SIEMENS AKTIENGESELLSCHAFT, 80333 München (DE)
(72) Erfinder: Spanier, Horst, Dipl.-Ing., 90482 Nürnberg (DE); Köster, Kay, Dipl.-Ing., 10409 Berlin (DE); Müller, Frank, Dipl.-Ing., 91056 Erlangen (DE); Wierth, Detlef, Dipl.-Ing., 12439 Berlin (DE)

(56) Entgegenhaltungen:
- DE-A- 2 455 030
- DE-A- 2 847 395
- DE-A- 3 205 129
- DE-A- 4 330 925
- FR-A- 2 551 215
- US-A- 4 126 269

## Beschreibung

Die Erfindung befasst sich mit einer Einrichtung zur selbsttätigen Beheizung eines Luftansauggitters für elektrische Geräte entsprechend dem Oberbegriff des Patentanspruches 1.

Bei einer Vielzahl von elektrischen Geräten, z.B. Fahrmotoren in Kraftfahrzeugen, Wasserfahrzeugen oder auch stationären Anlagen, z.B. Notstromaggregaten oder Klimaanlagen, wird zur Kühlung der Geräte ein Kühlmedium über ein Luftansauggitter geleitet. In Schienenfahrzeugen z.B. werden speziell gestaltete Ansauggitter für die Kühlluft-Ansaugung der Fahrmotoren und der Leistungselektronik eingesetzt, die gleichzeitig Staubpartikel und andere Verunreinigungen aus dem Luftstrom abscheiden.

Bei extremen Witterungsverhältnissen im Winter bzw. beim Einsatz in Kältegebieten kann es infolge Schneefall oder Eisregen zur Vereisung bzw. zum Verschluß des Ansauggitters kommen. Dies trifft sowohl für Anlagen im Unterflurbereich (Triebwagen) als auch im Dachbereich (Lokomotiven, Straßenbahnen) und in den Seitenwandungen von Reisezugwagen zu. Eine Vereisung bzw. ein Verschluss des Ansauggitters führt dazu, dass durch das Filtersystem des Ansauggitters keine Kühlluft mehr durchströmen kann, wodurch die Funktion des elektrischen Gerätes beeinträchtigt bzw. in Frage gestellt ist.

Um Ausfälle infolge von starken Schneefällen bzw. Vereisungen zu verhindern, wurde in der nicht vorveröffentlichten deutschen Patentanmeldung P 19 752 669 vorgeschlagen, eine Heizvorrichtung vorzusehen, durch die wenigstens ein Ansaugfilter zumindest teilweise beheizbar ist. Die Einrichtung erhält wenigstens einen Strömungswächter, durch den die Strömung des Kühlmediums erfaßbar ist sowie wenigstens eine Schalteinrichtung, durch die die Heizeinrichtung bei fehlender Strömung zuschaltbar und bei Wiedereintreten der Strömung abschaltbar ist. Die Strömungsbewegung des Kühlmediums kann durch einen Lüfter erzeugt bzw. verstärkt werden, der während des Heizvorganges abgeschaltet werden kann, falls dies aus strömungs- und/oder klimatechnischen Gründen erforderlich sein sollte.

Aus DE 32 05 129 A1 ist eine Vorrichtung zum Erkennen einer Eis- und/oder Reifbildung bekannt, bei der das Erkennen auf optischem Wege erfolgt. Hierzu wird auf die mit einer Eis- bzw. Reifschicht überzogenen Oberfläche ein Strahl polarisierten Lichts geworfen. Der reflektierte Lichtstrahl gelangt zu einer Lichtempfangseinrichtung mit Polarisationsfilter und Detektor. Bei vorhandener Eis- oder Reifschicht wird das Licht depolarisiert und durch das Filter auf eine Fotodiode gelenkt, von dem Detektor erfaßt und in ein entsprechendes Anzeigesignal umgewandelt. Das Signal kann außerdem dazu herangezogen werden, eine Heizeinrichtung einzuschalten und so einen Abtauvorgang einzuleiten, durch den die Vereisung bzw. Reifbildung beseitigt werden kann.

Aus DE 24 55 030 A1 ist es außerdem bekannt, zur Kühlung elektronischer Geräte Kühlluft einzusetzen und die Luftströmung mit Hilfe eines Sensors zu überwachen, indem z.B bei Unterschreiten einer für eine ausreichende Kühlung erforderliche Strömung oder bei Ausfall der Kühlung ein Warnsignal abgegeben wird.

Aus DE 43 30 925 C2 ist es weiterhin bekannt, bei Kühlgeräten in Schaltschränken oder Elekronikgehäusen das Vereisen des Verdampfers eines Wärmetauschers anzuzeigen und gegebenenfalls das Kühlgerät abzuschalten.

Aus DE 28 47 395 A1 ist eine Frostschutzeinrichtung für Außenluft- Ansauggitter von Belüftungs- oder Klimaanlagen bekannt, bei der ein aus Metall bestehendes Ansauggitter als Heizleiter ausgeführt ist. Die Heizung des Ansauggitters wirkt mit einem Außentemperaturfühler und/oder mit einem im Ansaugkanal angeordneten Druckfühler zusammen und zwar dergestalt, dass bei einer bestimmten Temperatur die Heizung eingeschaltet und bei Erreichen einer höheren Temperatur wieder ausgeschaltet wird. Der Druckfühler kann bei Erreichen eines durch das Zusetzen des Ansauggitters bewirkten Unterdruckes die Heizung ebenfalls ein- und bei Erreichen des normalen Druckes wieder ausschalten.

Der im Anspruch 1 angegebenen Erfindung liegt die Aufgabe zugrunde, eine Einrichtung zur Beheizung eines Luftansauggitters der eingangs genannten Art anzugeben, welches den Betreiber hinsichtlich der Betriebsüberwachung entlastet und die Beheizung des Luftansauggitters selbsttätig vornimmt.

Bei der erfindungsgemäßen Einrichtung prüft die elektronische Steuer- und Regeleinrichtung die Betriebsbedingungen und entscheidet selbständig entsprechend einem Ablaufdiagramm über den Einsatz der vorzugsweise in dem Ansauggitter integrierten Heizungsanlage. Es wird also ein unabhängiges selbststeuerndes System geschaffen, welches in sich geschlossen ist und Ausfälle von Luftansaugfiltern infolge starken Schneefalls bzw. Vereisung vorbeugend verhindert bzw. beseitigt. Die Steuer- und Regeleinrichtung ist in eine übergeordnete Steuerung, bei Fahrzeugen vorteilhafterweise in die vorhandene Fahrzeugsteuerung, eingebunden und informiert den Betreiber bzw. Fahrzeugführer ständig über den aktuellen Zustand der Luftansauganlage.

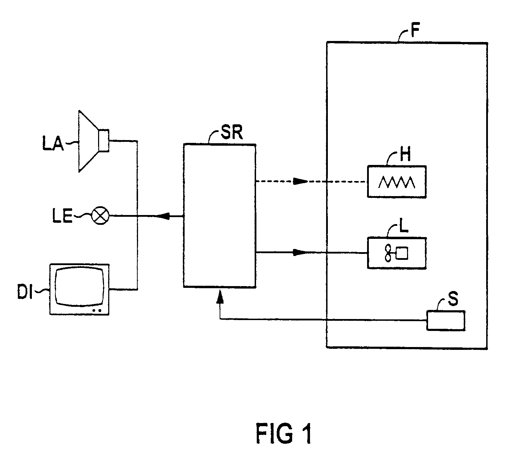

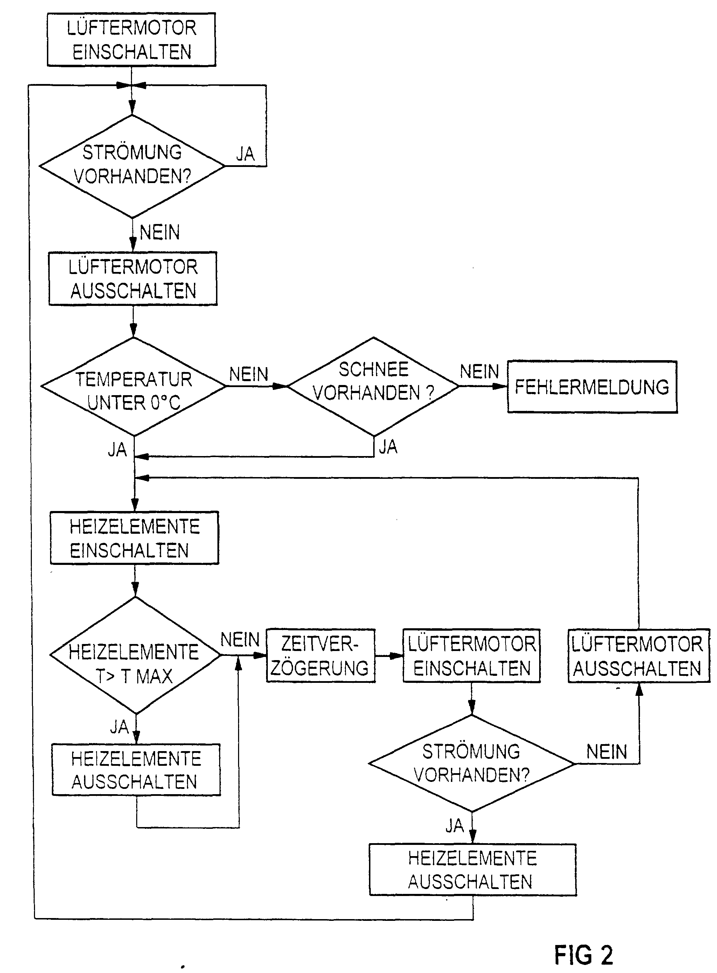

Die Erfindung wird nachfolgend anhand der Figuren 1 und 2 näher erläutert.

Figur 1 zeigt anhand eines Blockschaltbildes die wesentlichen Teile, die für die erfindungsgemäße Einrichtung notwendig sind.

Das mit F bezeichnete Luftansauggitter kann, wie in der eingangs erwähnten deutschen Patentanmeldung beschrieben, aufgebaut sein und eine oder mehrere Filtereinrichtungen beinhalten. Das Ansauggitter enthält eine Heizvorrichtung H, die aus einem oder mehreren Heizelementen bestehen kann, welche zumindest innerhalb eines Einströmprofils angeordnet sein können. Das Einströmprofil des Luftansauggitters kann selbst als Heizelement ausgebildet sein.

Um eine Luftströmung für die Kühlung des hier nicht gezeigten elektrischen Gerätes zu erhalten bzw. die Luftströmung zu verstärken, ist ein elektrisch angetriebener Lüfter (L) vorhanden. Des weiteren ist eine Sensoreinrichtung (S) vorhanden, die mindestens einen Sensor umfaßt, der das Vorhandensein einer Luftströmung (Strömungswächter) und/oder die Temperatur im Bereich des Luftansauggitters erfaßt (Temperatursensor).

Die Heizung (H), der Lüfter (L) und die Sensoreinheit (S) sind mit einer Steuer- und Regeleinrichtung (SR) verbunden, die Teil der Fahrzeugsteuerung ist. In die Steuer- und Regeleinrichtung (SR) werden aktuelle Informationen über die Luftströmung bzw. über die Temperatur im Bereich des Luftansauggitters eingegeben; nach Verarbeitung der Informationen werden Signale an die Heizeinrichtung (H) bzw. den Lüfter (L) gegeben. Zur Information über den Betriebszustand sind akustische und/oder optische Einrichtungen vorhanden, z.B. ein Lautsprecher (LA), eine Anzeigeleuchte (LE) oder ein Display (DI).

Anhand des Ablaufdiagramms gemäß Figur 2 wird die Funktion der Einrichtung näher erläutert.

Es wird vorteilhafterweise davon ausgegangen, daß zu Beginn des Regelprozesses der Lüfter (L) eingeschaltet ist. Über die Sensoreinheit (S) erhält die Steuer- und Regeleinrichtung (SR) die Information, ob Strömung vorhanden ist. Ist keine Strömung vorhanden, wird der Lüfter (L) ausgeschaltet. Die Sensoreinheit (S) ergibt ferner die Information, ob die Temperatur im Bereich des Luftansauggitters unterhalb oder oberhalb des Gefrierpunktes liegt. Liegt die Temperatur unterhalb des Gefrierpunktes, wird die Heizvorrichtung eingeschaltet, liegt die Temperatur oberhalb des Gefrierpunktes, wird über den Temperatursensor die Information gegeben, ob evtl. Schnee vorhanden sein könnte. Hier kann z.B. in der Regeleinrichtung eingegeben werden, daß bei Temperaturen zwischen 0 und 5°C, vorzugsweise zwischen 0 und 2°C, davon auszugehen ist, daß evtl. Schnee vorhanden ist. Liegen die Temperaturen höher, ist davon auszugehen, daß kein Schnee vorhanden ist, vielmehr ein Fehler in der Anlage vorliegen muß. In diesem Falle wird über eines der optischen und/oder akustischen Anzeigeelemente (LA, LE oder DI) eine Fehlermeldung gegeben. Ist aufgrund der Temperaturwerte davon auszugehen, daß Schnee vorhanden ist, so wird ebenfalls die Heizeinrichtung eingeschaltet. Der Temperaturfühler der Sensoreinheit (S) erfaßt ferner, ob die maximale Aufheiztemperatur erreicht ist oder nicht. Liegt die erreichte Temperatur über der maximal zulässigen Temperatur, wird die Heizeinrichtung abgeschaltet. Liegt die aktuelle Temperatur niedriger als die maximale Temperatur, wird über ein Zeitverzögerungsglied nach einer vorgegebenen Zeit der Lüfter (L) eingeschaltet. Wenn über den Strömungswächter die Information gegeben wird, daß Strömung vorhanden ist, wird die Heizeinrichtung abgeschaltet. Liegt keine Strömung vor, so wird der Lüfter ausgeschaltet und die Heizeinrichtung wieder eingeschaltet. Danach erfolgt der Abfragezyklus wie bereits beschrieben.

Vorteilhaft ist es, den Abfragezyklus zeitlich zu begrenzen, um so einen anderweitigen Verschluß des Luftansaugsystems, z.B. durch Fremdkörper, zu erkennen.

Die Betriebsbedingungen werden in entsprechend festgelegten Zyklen wiederholt geprüft, so daß die Funktionssicherheit des Luftansaugens ständig gewährleistet ist. Bei sich verschlechternden Bedingungen werden Heizeinrichtung und Lüfter, wie beschrieben, selbsttätig wieder in Betrieb gesetzt.

## Patentansprüche

1. Einrichtung zur selbsttätigen Beheizung eines Luftansauggitters (F) für elektrische Geräte, umfassend eine Heizeinrichtung (H) mit mindestens einem Heizelement, eine Sensoreinheit (S) mit mindestens einem, zumindest die Temperatur im Bereich des Luftansauggitters (F) erfassenden Sensor,und einem im Bereich des Luftansauggitters (F)Vorgesehenen die Luftströmung erfassenden Sensor und eine die Heizeinrichtung (H) in Abhängigkeit von der Temperatur zu- und abschaltende Steuer- und Regeleinrichtung (SR), **dadurch gekennzeichnet , dass** ferner mindestens ein von der Steuer- und Regeleinrichtung (SR) aktivierbarer Lüfter (L) vorhanden ist, der ausgeschaltet wird bzw. deaktiviert bleibt, solange die Heizeinrichtung (H) eingeschaltet ist und keine Luftströmung vorhanden ist, und der eingeschaltet bleibt bzw. aktiviert wird, wenn Luftströmung vorhanden ist.

2. Einrichtung nach Anspruch 1, umfassend ferner akustische und/oder optische Anzeigemittel (LA, LE, DI), welche bei eingeschalteter Heizeinrichtung (H) und bei abgeschaltetem bzw. deaktiviertem Lüfter (L) und bei einer Temperatur, die deutlich oberhalb des Gefrierpunktes, vorzugsweise oberhalb eines Temperaturbereiches von 0 bis 5°C liegt, eine akustische und/oder optische Fehlermeldung geben.

3. Einrichtung nach Anspruch 2, umfassend ferner ein Zeitverzögerungsglied, welches nach Abschalten der Heizeinrichtung (H) bei Erreichen einer maximalen Aufheiztemperatur den Lüfter (L) mit einer Zeitverzögerung einschaltet.

4. Einrichtung nach Anspruch 1, bei der die Steuer- und Regeleinrichtung (SR) ein Ablaufprogramm enthält, welches folgende Schritte umfasst:
- der Steuer- und Regeleinrichtung (SR) wird über die Sensoreinheit (S) die Information zugeführt, ob Luftströmung vorhanden ist
- ist keine Luftströmung vorhanden, wird der Lüfter (L) ausgeschaltet bzw. bleibt deaktiviert, ist Luftströmung vorhanden, bleibt der Lüfter eingeschaltet bzw. er wird aktiviert
- liegt bei abgeschaltetem Lüfter die Temperatur unterhalb des Gefrierpunktes, wird die Heizeinrichtung (H) eingeschaltet, liegt die Temperatur oberhalb des Gefrierpunktes, vorzugsweise innerhalb eines Temperaturbereiches von 0 bis 5°C, wird die Heizeinrichtung (H) ebenfalls eingeschaltet, liegt dagegen die Temperatur sehr viel höher, wird eine akustische und/oder optische Fehlermeldung gegeben
- wird eine maximale Aufheiztemperatur erreicht bzw. überschritten, wird die Heizeinrichtung (H) abgeschaltet; liegt die Aufheiztemperatur unterhalb dieser maximalen Temperatur wird der Lüfter (L), vorzugsweise mit einer Zeitverzögerung, eingeschaltet
- ist sodann Luftströmung vorhanden, wird die Heizeinrichtung (H) abgeschaltet, liegt keine Luftströmung vor, wird der Lüfter (L) abgeschaltet und die Heizeinrichtung erneut eingeschaltet.

5. Einrichtung nach Anspruch 1, bei der die Steuer- und Regeleinrichtung (SR) ein Ablaufprogramm enthält, welches bei vorhandener Luftströmung und eingeschaltetem Lüfter sowie einsetzenden Niederschlägen bei Temperaturen um oder unterhalb des Gefrierpunktes die Heizeinrichtung (H) einschaltet.

6. Einrichtung nach einem der Ansprüche 1 bis 5, **gekennzeichnet durch** die Anwendung bei Schienenfahrzeugen.

## Claims

1. Device for automatically heating an air-intake grid (F) for electrical apparatus, comprising a heating device (H) that has at least one heating element, a sensor unit (S) that has at least one sensor that detects at least the temperature in the region of the air-intake grid (F) and a sensor that is provided in the region of the air-intake grid (F) and detects the air flow, and a control and regulating device (SR) which switches the heating device (H) on and off as a function of the temperature, **characterised in that**, furthermore, at least one fan (L) is provided that can be activated by the control and regulating device (SR) and which is switched off or remains deactivated as long as the heating device (H) is switched on and there is no air flow and which remains switched on or is activated when there is air flow.

2. Device according to claim 1, comprising, furthermore, acoustic and/or visual indicator means (LA, LE, DI) which transmit an acoustic and/or visual error message if the heating device (H) is switched on and if the fan (L) is switched off or deactivated and if the temperature is clearly above freezing point, preferably above a temperature range of 0 to 5°C.

3. Device according to claim 2, comprising, furthermore, a time-delay element which switches on the fan (L) with a time delay after the heating device (H) has been switched off upon attainment of a maximum heating-up temperature.

4. Device according to claim 1, wherein the control and regulating device (SR) contains a sequential program which comprises the following steps:
- information as to whether there is air flow is fed to the control and regulating device (SR) by way of the sensor unit (S);
- if there is no air flow, the fan (L) is switched off or remains deactivated; if there is air flow, the fan remains switched on or is activated;
- if, with the fan switched off, the temperature lies below freezing point, the heating device (H) is switched on; if the temperature lies above freezing point, preferably within a temperature range of 0 to 5°C, the heating device (H) is also switched on; if, on the other hand, the temperature is very much higher, an acoustic and/or visual error message is transmitted;
- if a maximum heating-up temperature is attained or exceeded, the heating device (H) is switched off; if the heating-up temperature lies below this maximum temperature, the fan (L) is switched on, preferably with a time delay;
- if there is air flow then, the heating device (H) is switched off; if there is no air flow, the fan (L) is switched off and the heating device is switched on again.

5. Device according to claim 1, wherein the control and regulating device (SR) contains a sequential program which, when there is air flow and the fan is switched on and also when precipitation is setting in at temperatures around or below freezing point, switches on the heating device (H).

6. Device according to one of claims 1 to 5, **characterised by** the application in rail vehicles.

## Revendications

1. Installation de chauffage automatique d'une grille d'admission d'air (F) pour des appareils électriques, qui comprend une installation de chauffage (H) ayant au moins un élément de chauffage, une unité de capteur (S) ayant au moins un capteur relevant au moins la température dans la zone de la grille d'admission d'air (F) et un capteur détectant le courant d'air dans la zone de la grille d'admission d'air (F), et une installation de commande et de réglage (SR) qui branche et qui débranche l'installation de chauffage (H) en fonction de la température, **caractérisée en ce qu'**il existe en outre au moins un ventilateur (L) activable par l'installation de commande et de réglage (SR) qui est débranché ou qui reste désactivé tant que l'installation de chauffage (H) est branchée et qu'il n'y a pas de courant d'air, et qui reste branché ou qui est activé lorsqu'il y a un courant d'air.

2. Installation selon la revendication 1 qui comprend en outre des moyens d'affichage acoustiques et/ou optiques (LA, LE, DI) qui fournissent un message d'erreur acoustique et/ou optique lorsque l'installation de chauffage (H) est branchée et lorsque le ventilateur (L) est débranché ou désactivé et lorsqu'une température se trouve significativement au-dessus du point de congélation, de préférence au-dessus d'une plage de température comprise entre 0 et 5 °C.

3. Installation selon la revendication 2 qui comprend en outre un élément de retardement temporel, qui branche le ventilateur (L) avec un retardement temporel lorsqu'une température d'échauffement maximale est atteinte après que l'installation de chauffage (H) a été débranchée.

4. Installation selon la revendication 1 pour laquelle l'installation de commande et de réglage (SR) contient un programme de déroulement qui comprend les étapes suivantes :
• l'information concernant la présence d'un courant d'air est fournie à l'installation de commande et de réglage (SR) au moyen de l'unité de capteur (S),
• s'il n'y a pas de courant d'air, le ventilateur (L) est débranché ou reste désactivé, s'il y a un courant d'air le ventilateur reste branché ou est activé,
• si la température se trouve au-dessous du point de congélation lorsque le ventilateur est débranché, l'installation de chauffage (H) est branchée, si la température se trouve au-dessus du point de congélation, de préférence à l'intérieur d'une plage de température comprise entre 0 et 5 °C, l'installation de chauffage (H) est aussi branchée, si par contre la température est très supérieure, on fournit un message d'erreur acoustique et/ou optique,
• si une température d'échauffement maximale est atteinte ou dépassée, l'installation de chauffage (H) est débranchée ; si la température d'échauffement se trouve au-dessous de cette température maximale, le ventilateur est branché de préférence avec un retardement temporel,
• si alors le courant d'air existe, l'installation de chauffage (H) est débranchée, s'il n'y a aucun courant d'air, le ventilateur (L) est débranché et l'installation de chauffage est à nouveau branchée.

5. Installation selon la revendication 1 pour laquelle l'installation de commande et de réglage (SR) contient un programme de déroulement qui branche l'installation de chauffage (H) lorsqu'il y a un courant d'air et que le ventilateur est branché et lorsque des précipitations qui ont lieu à des températures proches ou inférieures au point de congélation.

6. Installation selon l'une des revendications 1 à 5 **caractérisée par** l'utilisation pour des véhicules sur rails.
